# FASCICULE DE BREVET EUROPEEN

(11) **EP 1 420 083 B1**
(45) Date de publication et mention de la délivrance du brevet: **28.02.2007**
(21) Numéro de dépôt: 03354078.2
(22) Date de dépôt: 08.10.2003
(51) Int. Cl.: C23C 30/00, C23C 28/00, C23C 14/14, C23C 16/26

(54) **Procédé de dépôt d'un revêtement de surface comportant au moins une couche mince homogène en métal et en carbone et revêtement de surface ainsi obtenu**
Verfahren zur Abscheidung einer Oberflächenbeschichtung, die mindestens ein dünnen, homogenen Film aus Metall und kohlenstoff enthält, und dadurch hergestellte Oberflächenbeschichtung
Method for depositing a surface coating comprising at least one thin, homogeneous layer of metal and carbon and corresponding surface coating

(30) Priorité: 12.10.2002 CH 16982002
(43) Date de publication de la demande: 19.05.2004
(73) Titulaire: Surcotec S.A., 1228 Plan-Les-Ouates (CH)
(72) Inventeur: Gremion, François, 74160 Saint-Julien-en-Genevois (FR); Matthey, Pierre, 1255 Veyrier (CH)
(74) Mandataire: Hecké, Gérard

(56) Documents cités:
- WO-A-00/47290
- US-A- 5 638 251
- US-A- 6 080 470
- US-B1- 6 340 245

## Description

### Domaine technique de l'invention

L'invention concerne un procédé de dépôt d'un revêtement de surface sur au moins une partie d'un objet comprenant au moins une étape de dépôt physique en phase vapeur d'un métal ou d'un alliage métallique comportant au moins ledit métal.

L'invention concerne également un revêtement de surface ainsi obtenu.

### État de la technique

II existe de nombreux procédés de dépôt de revêtement de surface métallique sur des objets de forme quelconque à revêtir. Ainsi, les dépôts physiques en phase vapeur sont couramment utilisés pour déposer des métaux sur un substrat. Cependant, les matériaux déposés présentent souvent une mauvaise résistance à l'usure ou une faible conductivité électrique. Les procédés galvaniques sont également couramment utilisés, mais ne permettent de déposer des matériaux que sur des supports conducteurs.

### Objet de l'invention

L'invention a pour but de proposer un procédé de dépôt permettant d'obtenir un revêtement de surface conducteur de dureté élevée, comportant au moins un métal et ayant une coloration particulière allant, plus particulièrement, d'un ton brunâtre jusqu'au noir.

Selon l'invention, ce but est atteint par les revendications annexées.

Plus particulièrement, ce but est atteint par le fait que le procédé consiste à déposer, simultanément audit métal, du carbone au moyen d'un mélange de gaz comprenant au moins un hydrocarbure et un gaz porteur, de manière à former au moins une couche mince composite homogène, ledit métal et le carbone n'étant pas liés chimiquement entre eux.

Selon un développement de l'invention, ledit métal est choisi parmi le groupe comprenant l'or, le platine, le palladium, le ruthénium, le rhodium et l'argent.

Selon un mode de réalisation préférentiel, le dépôt du revêtement de surface est réalisé à une température de dépôt comprise entre 50°C et 250°C.

Selon une autre caractéristique de l'invention, le procédé consiste à déposer au moins une couche intermédiaire sur l'objet, avant le dépôt de la couche mince composite homogène.

Selon une autre caractéristique de l'invention, le revêtement comporte au moins une couche mince composite homogène comprenant du carbone et un métal non liés chimiquement entre eux.

Il est ainsi possible d'obtenir un revêtement de surface ayant une coloration particulière et présentant, de préférence, une bonne résistance à l'usure et un coefficient de frottement faible.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente, en coupe, un premier mode de réalisation d'un revêtement de surface selon l'invention, disposé sur un objet à revêtir.
Les figures 2 à 4 représentent, en coupe, des variantes de réalisation d'un revêtement de surface selon l'invention, disposé sur un objet à revêtir.

### Description de modes particuliers de réalisation.

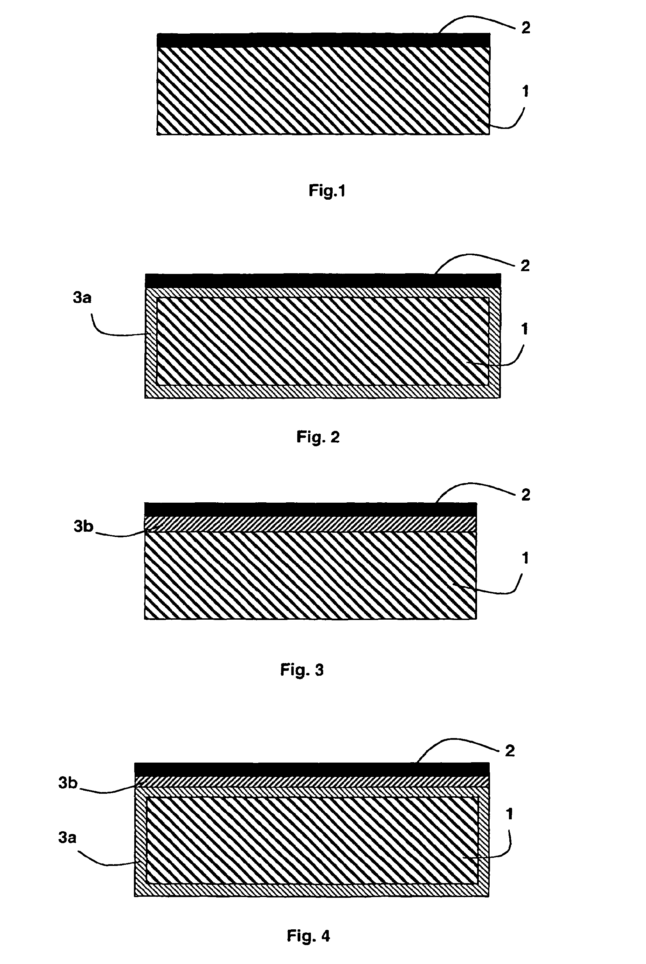

Comme représenté à la figure 1, un revêtement de surface est disposé sur au moins une partie d'un objet 1 et plus particulièrement sur une face d'un objet 1. L'objet 1 à revêtir peut être, par exemple, un objet de luxe tel qu'un bijou, un stylo, un briquet, une monture de lunettes ou un composant d'horlogerie...

Le revêtement de surface comporte au moins une couche mince composite homogène 2, ayant, de préférence, une épaisseur comprise entre 0,5 micromètre et 5 micromètres et comportant au moins un métal et du carbone. Dans la couche mince composite 2, le carbone et le métal ne sont pas liés chimiquement entre eux, c'est-à-dire qu'aucune liaison chimique n'a lieu entre le carbone et le métal. Ainsi, on peut considérer que la couche mince 2 comprend deux phases comportant respectivement des liaisons carbone-carbone et métal-métal (ou alliage métallique-alliage métallique), les deux phases formant un ensemble homogène. Dans la couche mince composite 2, la teneur atomique en carbone est, de préférence, comprise entre 5% et 98%, tandis que la teneur en poids du métal est, de préférence, comprise entre 5% et 90%. Le métal de la couche mince composite 2 est, de préférence, choisi parmi l'or, le platine, le palladium, le ruthénium, le rhodium et l'argent. Le métal peut également faire partie d'un alliage métallique.

La présence de carbone non lié chimiquement au métal confère à la couche mince composite homogène 2 une couleur particulière qui peut varier d'un ton brunâtre jusqu'au noir, selon la teneur atomique en carbone. De plus, un tel revêtement de surface présente l'avantage d'améliorer la résistance à l'usure de la pièce revêtue et diminue les coefficients de frottement entre deux pièces. Enfin, étant donné que la densité du carbone est très inférieure à celle des métaux et notamment à celle de l'or, le fait d'associer du carbone à un métal sans les lier chimiquement présente également l'avantage de pouvoir réaliser des revêtements de surface de couleur brune à noire ayant des proportions en carbone et en métal de l'ordre de 50 % en poids tout en utilisant une proportion atomique de carbone très supérieure à celle du métal. En effet, lorsque l'on souhaite obtenir un revêtement de surface noir, notamment en utilisant de l'or, du platine ou du palladium comme métal pour la couche mince composite 2, la teneur en métal est avantageusement d'environ 50% en poids tandis que la teneur atomique en carbone est, de préférence, comprise entre 80% et 98%.

Selon l'invention, une telle couche mince homogène 2 est obtenue, en déposant sur l'objet 1, du carbone simultanément au dépôt physique en phase vapeur du métal. Le dépôt simultané de carbone et de métal est réalisé au moyen d'un mélange de gaz comprenant au moins un hydrocarbure, par exemple le méthane, et un gaz porteur. La température de dépôt du revêtement de surface et notamment du carbone et du métal est, de préférence, comprise entre 50°C et 250°C.

Ainsi, l'hydrocarbure gazeux est décomposé par ionisation dans une chambre de dépôt disposée dans un vide au moins partiel de manière à former du carbone quasi pur, pouvant comporter une faible proportion d'hydrogène et destiné à être déposé sur l'objet 1. Simultanément, une cible comportant du métal ou un alliage métallique subit un bombardement ionique destiné à arracher les particules métalliques de la cible et à les transporter, via le gaz porteur, vers l'objet à revêtir. La cible est, de préférence, constituée par le métal ou l'alliage métallique destiné à être déposé sur l'objet 1 et le gaz porteur peut être de tout type connu dans le domaine des dépôts en phase vapeur. Le gaz porteur peut, notamment, être choisi parmi l'argon, l'azote ou un mélange de ces gaz. Un tel procédé permet ainsi, de réaliser, à la fois, un dépôt physique en phase vapeur pour le métal et un dépôt chimique en phase vapeur pour le carbone.

A titre d'exemple, on peut utiliser comme gaz porteur, de l'azote à un débit de 9 cm³ par minute. L'azote et le gaz hydrocarbure sont alors injectés dans la chambre de dépôt à l'intérieur de laquelle la pression est d'environ 2mBar. L'objet à revêtir est placé dans la chambre de dépôt sur un plateau aéré permettant à l'objet de baigner dans un plasma, à quelques centimètres de la cible. Une excitation du plasma par radio-fréquence (à 13,56MHz) est créée à une puissance de 500W, de sorte que le plasma bombarde la cible pour en extraire les particules métalliques et ionise le gaz hydrocarbure. Les particules métalliques et le carbone provenant de l'ionisation du gaz hydrocarbure sont ainsi déposés sur l'objet à revêtir. Le dépôt d'une couche mince homogène en carbone et en métal, d'une épaisseur comprise entre 1 et 2 micromètres, est alors obtenu en 30 minutes environ.

Dans un mode particulier de réalisation, le revêtement de surface peut également comporter au moins une couche intermédiaire disposée entre l'objet 1 et la couche mince composite homogène 2. La couche mince intermédiaire a, de préférence, une épaisseur d'au moins 0,1 micromètre et elle est déposée, avant le dépôt de la couche mince homogène 2. La couche mince intermédiaire peut, par exemple, améliorer l'adhérence de la couche mince composite homogène sur l'objet à revêtir et/ou renforcer la résistance à l'usure de la couche mince composite homogène 2.

La couche mince intermédiaire peut, par exemple, être constituée par un métal, un alliage métallique ou un composé métallique, le métal contenu dans une telle couche intermédiaire pouvant être différent ou non du métal contenu dans la couche mince composite homogène 2. Ainsi, une telle couche mince intermédiaire, en métal, en alliage métallique ou en composé métallique peut être déposée par tout type de moyens connus. Elle peut, par exemple être déposée en phase vapeur ou par voie aqueuse, soit par dépôt chimique soit par dépôt électrolytique. Elle peut également, être constituée par du carbone, et, dans ce cas, la couche mince intermédiaire est, de préférence, déposée par un dépôt chimique en phase vapeur.

A titre d'exemple, comme représentée à la figure 2, une couche mince intermédiaire 3a, en métal et de préférence en métal noble tel que de l'or ou de l'argent, recouvre la totalité de la surface de l'objet 1. Une partie de la couche mince intermédiaire 3a est recouverte par la couche mince composite homogène 2, de sorte qu'au moins une face de l'objet 1 est recouverte par la superposition des couches intermédiaire 3a et composite homogène 2. Ainsi, pour un objet revêtu d'une couche composite homogène, en or noir 12 Carats et d'une épaisseur d'environ 1 micromètre, la couche mince intermédiaire 3a disposée entre l'objet et la couche composite 2 permet d'obtenir un objet pouvant porter la mention "plaqué 14 carats" ou "plaqué 18 carats", selon son épaisseur.

A la figure 3, une couche mince intermédiaire 3b en carbone, recouvre une face de l'objet 1 et elle est, elle même, totalement recouverte par la couche mince composite homogène 2. La couche intermédiaire 3b en carbone améliore la dureté du revêtement de surface tout en lui garantissant une coloration particulière, même lorsque la couche mince composite homogène 2 subit une altération telle qu'une étape d'abrasion.

Selon une variante de réalisation représentée à la figure 4, une couche mince intermédiaire 3b en carbone, telle que celle représentée à la figure 3, est disposée entre une couche mince intermédiaire 3a en métal, en alliage métallique ou en composé métallique, telle que celle représentée à la figure 2, et la couche mince composite homogène 2. La couche mince intermédiaire 3b en carbone est alors disposée sur la face de l'objet 1 destinée à être recouverte par la couche mince composite homogène 2.

Un revêtement selon l'invention peut, par exemple, être déposé sur des contacts électriques, afin d'augmenter la résistance à l'usure des contacts. Le revêtement peut être déposé sur tout matériau supportant la température de dépôt, y compris les matériaux isolants, par exemple les céramiques.

## Revendications

1. Procédé de dépôt d'un revêtement de surface sur au moins une partie d'un objet (1) comprenant au moins une étape de dépôt physique en phase vapeur d'un métal ou d'un alliage métallique comportant au moins ledit métal, **caractérisé en ce que** le métal étant choisi parmi le groupe comprenant l'or, le platine, le palladium, le ruthénium, le rhodium et l'argent, le procédé consiste à déposer, simultanément audit métal, du carbone au moyen d'un mélange de gaz comprenant au moins un hydrocarbure et un gaz porteur, de manière à former au moins une couche mince composite homogène (2), ledit métal et le carbone n'étant pas liés chimiquement entre eux.

2. Procédé selon la revendication 1, **caractérisé en ce que** le dépôt du revêtement de surface est réalisé à une température de dépôt comprise entre 50°C et 250°C.

3. Procédé selon l'une des revendications 1 et 2, **caractérisé en ce qu**'il consiste à déposer au moins une couche intermédiaire (3a, 3b) sur l'objet, avant le dépôt de la couche mince composite homogène.

4. Procédé selon la revendication 3, **caractérisé en ce que** la couche intermédiaire (3b) étant constituée par du carbone, le dépôt de ladite couche intermédiaire (3b) est un dépôt chimique en phase vapeur.

5. Revêtement de surface obtenu par le procédé de dépôt selon l'une quelconque des revendications 1 à 4, **caractérisé en ce qu**'il comporte au moins une couche mince composite homogène (2) comprenant du carbone et ledit métal non liés chimiquement entre eux.

6. Revêtement de surface selon la revendication 5, **caractérisé en ce que** la teneur atomique en carbone, dans la couche mince composite homogène (2), est comprise entre 5% et 98%.

7. Revêtement de surface selon l'une des revendications 5 et 6, **caractérisé en ce que** la teneur en poids dudit métal, dans la couche mince composite homogène (2), est comprise entre 5% et 90%.

8. Revêtement de surface selon l'une quelconque des revendications 5 à 7, **caractérisé en ce que** l'épaisseur de la couche mince composite homogène (2) est comprise entre 0,5 micromètre et 5 micromètres.

9. Revêtement de surface selon l'une quelconque des revendications 5 à 8, **caractérisé en ce qu**'il comporte au moins une couche mince intermédiaire (3a, 3b) destinée à être disposée entre l'objet et la couche mince composite homogène.

10. Revêtement de surface selon la revendication 9, **caractérisé en ce que** l'épaisseur de la couche mince intermédiaire (3a, 3b) est supérieure ou égale à 0,1 micromètre.

11. Revêtement de surface selon l'une des revendications 9 et 10, **caractérisé en ce que** la couche mince intermédiaire (3b) est en carbone.

12. Revêtement de surface selon l'une des revendications 9 et 10, **caractérisé en ce que** la couche mince intermédiaire (3a) est constituée par un métal, un alliage métallique ou un composé métallique.

## Claims

1. Method for depositing a surface coating on at least a part of an object (1) comprising at least a step of physical vapour deposition of a metal or of a metal alloy comprising at least said metal, **characterised in that** the metal being chosen among the group comprising gold, platinum, palladium, ruthenium, rhodium and silver, the method consists into depositing carbon, simultaneously with said metal, by means of a gas mixture comprising at least a hydrocarbon and a carrier gas, so as to form at least a homogeneous composite thin layer (2), said metal and carbon being not chemically bonded together.

2. Method according to claim 1, **characterised in that** the surface coating is deposited at a deposition temperature comprised between 50°C and 250°C.

3. Method according to one of the claims 1 and 2, **characterised in that** it consists into depositing at least an intermediate layer (3a, 3b) on the object, before the homogeneous composite thin layer is deposited.

4. Method according to claim 3, **characterised in that** the intermediate layer (3b) being formed by carbon, said intermediate layer (3b) is deposited by chemical vapour deposition.

5. Surface coating obtained by the method for depositing according to any one of the claims 1 to 4, **characterised in that** it comprises at least a homogeneous composite thin layer (2) comprising carbon and said metal, which are not chemically bonded together.

6. Surface coating according to claim 5, **characterised in that** the atomic content of carbon in the homogeneous composite thin layer (2) is comprised between 5% and 98%.

7. Surface coating according to one of the claims 5 and 6, **characterised in that** the weight content of metal in the homogeneous composite thin layer (2) is comprised between 5% and 90%.

8. Surface coating according to any one of the claims 5 to 7, **characterised in that** the thickness of the homogeneous composite thin layer (2) is comprised between 0,5 micrometer and 5 micrometers.

9. Surface coating according to any one of the claims 5 to 8, **characterised in that** it comprises at least an intermediate thin layer (3a, 3b) designed to be arranged between the object and the homogeneous composite thin layer.

10. Surface coating according to claim 9, **characterised in that** the thickness of the intermediate thin layer (3a, 3b) is greater than or equal to 0,1 micrometer.

11. Surface coating according to one of the claims 9 and 10, **characterised in that** the intermediate thin layer (3b) is made of carbon.

12. Surface coating according to one of the claims 9 and 10, **characterised in that** the intermediate thin layer (3a) is formed by a metal, a metal alloy or a metallic compound.

## Patentansprüche

1. Verfahren zum Abscheiden einer Oberflächenbeschichtung auf mindestens einem Teil eines Gegenstands (1), das mindestens einen Schritt zur physikalischen Dampfabscheidun eines Metalls oder einer Metalllegierung umfasst, das/die mindestens das genannte Metall umfasst, **dadurch gekennzeichnet, dass** das Metall aus der aus Gold, Platin, Palladium, Ruthenium, Rhodium und Silber gebildeten Gruppe ausgewählt ist, wobei das Verfahren darin besteht, gleichzeitig mit dem genannten Metall Kohlenstoff mittels eines Gasgemischs abzuscheiden, das mindestens einen Kohlenwasserstoff und ein Trägergas umfasst, um mindestens eine dünne, homogene Verbundschicht (2) zu bilden, wobei das Metall und der Kohlenstoff chemisch nicht aneinander gebunden sind.

2. Verfahren nach Anspruch 1, **dadurch gekennzeichnet, dass** das Abscheiden der Oberflächenbeschichtung bei einer Abscheidungstemperatur von 50 bis 250°C erfolgt.

3. Verfahren nach einem der Ansprüche 1 und 2, **dadurch gekennzeichnet, dass** es darin besteht, dass vor dem Abscheiden der dünnen, homogenen Verbundschicht mindestens eine Zwischenschicht (3a, 3b) auf den Gegenstand aufgebracht wird.

4. Verfahren nach Anspruch 3, **dadurch gekennzeichnet, dass** die Zwischenschicht (3b) aus Kohlenstoff besteht, wobei die Abscheidung der genannten Zwischenschicht (3b) eine chemische Dampfabscheidung ist.

5. Oberflächenbeschichtung, die nach dem Abscheidungsverfahren nach einem der Ansprüche 1 bis 4 erhalten wurde, **dadurch gekennzeichnet, dass** sie mindestens eine dünne, homogene Verbundschicht (2) umfasst, die Kohlenstoff und das genannte Metall enthält, die chemisch nicht aneinander gebunden sind.

6. Oberflächenbeschichtung nach Anspruch 5, **dadurch gekennzeichnet, dass** der Atomanteil an Kohlenstoff in der dünnen, homogenen Verbundschicht (2) 5 bis 98 % beträgt.

7. Oberflächenbeschichtung nach einem der Ansprüche 5 und 6, **dadurch gekennzeichnet, dass** der Gewichtanteil des genannten Metalls in der dünnen, homogenen Verbundschicht (2) 5 bis 90 % beträgt.

8. Oberflächenbeschichtung nach einem der Ansprüche 5 bis 7, **dadurch gekennzeichnet, dass** die Dicke der dünnen, homogenen Verbundschicht (2) 0,5 bis 5 Mikrometer beträgt.

9. Oberflächenbeschichtung nach einem der Ansprüche 5 bis 8, **dadurch gekennzeichnet, dass** sie mindestens eine dünne Zwischenschicht (3a, 3b) umfasst, die dazu bestimmt ist, zwischen dem Gegenstand und der dünnen, homogenen Verbundschicht aufgebracht zu werden.

10. Oberflächenbeschichtung nach Anspruch 9, **dadurch gekennzeichnet, dass** die Dicke der dünnen Zwischenschicht (3a, 3b) größer als oder gleich 0,1 Mikrometer ist.

11. Oberflächenbeschichtung nach einem der Ansprüche 9 und 10, **dadurch gekennzeichnet, dass** die dünne Zwischenschicht (3b) aus Kohlenstoff besteht.

12. Oberflächenbeschichtung nach einem der Ansprüche 9 und 10, **dadurch gekennzeichnet, dass** die dünne Zwischenschicht (3a) aus einem Metall, einer Metalllegierung oder einer Metallverbindung besteht.
